# EUROPÄISCHE PATENTSCHRIFT

(11) **EP 0 373 473 B1**
(45) Veröffentlichungstag und Bekanntmachung des Hinweises auf die Patenterteilung: **13.03.1996**
(21) Anmeldenummer: 89122351.3
(22) Anmeldetag: 04.12.1989
(51) Int. Cl.: G03F 7/032

(54) **Photopolymerisierbares elastomeres Gemisch und dieses enthaltendes Aufzeichnungsmaterial für die Herstellung von ozonresistenten Flexodruckformen**
Photopolymerizable elastomeric mixture and recording material, containing this mixture, for the production of ozone resistant flexographic printing plates
Mélange photopolymérisable élastomère et matériau pour l'enregistrement contenant ce mélange, pour la fabrication de plaques d'impression flexographiques résistantes à l'ozone

(30) Priorität: 13.12.1988 DE 3841853
(43) Veröffentlichungstag der Anmeldung: 20.06.1990
(73) Patentinhaber: E.I. DU PONT DE NEMOURS & COMPANY INCORPORATED, Wilmington Delaware 19898 (US)
(72) Erfinder: Schlosser, Hans-Joachim, Dr.-Dipl.-Chem., D-6200 Wiesbaden (DE)
(74) Vertreter: Pistor, Wolfgang

(56) Entgegenhaltungen:
- WO-A-88/02135
- US-A- 4 065 430
- US-A- 4 369 246

## Beschreibung

Die Erfindung betrifft ein photopolymerisierbares elastomeres Gemisch zur Herstellung von ozonresistenten Flexodruckformen, ausgenommen solchen, die mit Wasser entwickelbar sind, im wesentlichen enthaltend ein elastomeres Bindemittel, eine radikalisch polymerisierbare olefinisch ungesättigte Verbindung und einen Photoinitiator.

Elastomere, insbesondere auf der Basis von Butadien oder Isopren für die Herstellung von Flexodruckformen sind seit langem bekannt und werden z.B. in den DE-B 22 15 090 (= US-A 4 423 135), DE-A 21 38 582 (= GB-A 1 358 062), 22 23 808 (= GB-A 1 395 822), DE-B 28 15 678 (= GB-A 1 577 706), DE-A 24 56 439 (= US-A 4 162 919) und 29 42 183 (= US-A 4 320 188) beschrieben. Es konnte allerdings festgestellt werden, daß Flexodruckformen, die diese Elastomere enthalten, schon bei geringster Anwesenheit von Ozon spröde werden und Risse aufweisen.

Das Ozon, das diesen Platten gefährlich wird, entsteht sowohl bei der bildmäßigen Belichtung der photopolymerisierbaren elastomeren Schicht, insbesondere bei Verwendung von UV-Licht, aber auch bei der Anwendung der belichteten und entwickelten Druckformen. Gerade hierbei treten besonders hohe Ozonkonzentrationen auf, insbesondere dann, wenn flexible Verpackungsmaterialien wie Papier oder Kunststoffe bedruckt werden sollen. Der Grund ist darin zu suchen, daß infolge der Gewährleistung einer genügenden hohen Haftung der Druckfarbe, z.B. auf den Kunststoffolien, diese vor dem Bedrucken coronabehandelt werden. Da bei der Coronabehandlung erhebliche Mengen an Ozon entstehen und die Behandlung dann am wirkungsvollsten ist, wenn diese unmittelbar vor dem Druckvorgang stattfindet, gerät die Druckform in erheblichem Maße mit dem aus diesem Prozess entstehenden Ozon in Kontakt. Erhöht wird die Anfälligkeit der entwickelten Druckform gegenüber Ozon noch dadurch, daß in den meisten Fällen eine Nachbehandlung der Druckformen mit Halogen, insbesondere mit Brom, erfolgt, die notwendig ist, um deren Klebrigkeit zu reduzieren.

Um die Resistenz der Druckform gegenüber dem rissebildenden und die Sprödigkeit fördernden Ozon zu verbessern, wurden verschiedene Wege eingeschlagen:

Aus der DE-A-22 15 090 ist bekannt, die Ozonresistenz durch Zusätze zu dem photopolymerisierbaren Gemisch zu verbessern. Als Zusätze werden mikrokristallines Wachs und Paraffinwachs, Dibutylthioharnstoff, 1,1,3,3-Tetramethylthioharnstoff, Norbornen, N-Phenyl-2-naphthylamin, ungesättigte Pflanzenöle, Ethylen/Vinylacetat-Copolymerisate, Polyurethane, chlorierte und/oder chlorsulfonierte Polyethylene, chlorierte Ethylen/Methacrylsäure-Copolymerisate, Polypentadiene, von Furfurol abgeleitete Harze, Ethylen/Propyliden-Kautschuke, Diethylenglykolester von Harzen und Copolymerisate von alpha-Methylstyrol mit Vinyltoluol vorgeschlagen.

Der Nachteil dieser Methode ist, daß die genannten Zusätze oftmals nicht ausreichen, um die geforderte Resistenz gegenüber Ozon zu gewährleisten, oder, wenn die wirksame Konzentration dieser Zusätze erhöht wird, das photopolymerisierbare Gemisch Trübungen in solchem Ausmaß aufweist, daß eine einwandfreie Bebilderung nicht mehr erzielt werden kann.

Ein anderes Verfahren zum Schutz einer Flexodruckform gegenüber Ozon wird in der DE-A 35 12 632 (= US-A 4 680 251) beschrieben. Dieses Verfahren fußt nicht auf irgendwelchen Zusätzen zu dem photopolymerisierbaren Gemisch, sondern beschreibt eine Nachbehandlung der entwickelten und mit Halogen behandelten Druckform mit bestimmten Polyglykolverbindungen. Die beschriebenen Polyglykolverbindungen sind entweder nicht oder nur monoverethert.

Ein wesentlicher Nachteil dieses Verfahrens ist der notwendige zusätzliche Behandlungsschritt. Ebenso lassen die beschriebenen Behandlungsreagenzien noch Wünsche hinsichtlich der erzielbaren Ozonresistenz offen.

In der WO 88/02135 ist ein photopolymerisierbares elastomeres Gemisch offenbart, das ein spezielles carboxylgruppenhaltiges Copolymer in Kombination mit einer stickstoffhaltigen Verbindung, ein ethylenisch ungesättigtes Monomer und einen Photoinitiator enthält. Das daraus hergestellte Aufzeichnungsmaterial wird nach dem bildmäßigen Bestrahlen mit Wasser entwickelt.

Es bestand deshalb die Aufgabe, ein photopolymerisierbares Gemisch, insbesondere geeignet für die Herstellung von Flexodruckformen, so zu modifizieren, daß deren Ozonresistenz gewährleistet ist und zugleich kein zusätzlicher Behandlungsschritt notwendig ist, um das geforderte Ziel zu erreichen. Die erreichte Ozonresistenz soll sich nicht negativ auf die Abbildungsqualität auswirken.

Gelöst wird die Aufgabe durch ein photopolymerisierbares elastomeres Gemisch der eingangs beschriebenen Gattung, das dadurch gekennzeichnet ist, daß es mindestens einen Polyglykolether nach der folgenden allgemeinen Formel I 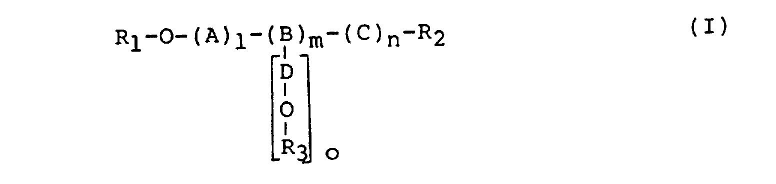 enthält, worin
- R₁ und R₂: Alkyl, insbesondere (C₁-C₃)Alkyl,
- R₃: Wasserstoff oder Alkyl, insbesondere (C₁-C₃)Alkyl,
- A, B, C und D: gleich oder verschieden sein können und Oxa-n- oder -iso-alkylen, insbesondere Oxa-n- oder -iso-(C₁-C₅)alkylen und
- l+m+n+o: 3 bis 40
bedeuten.

Bevorzugt ist, wenn m und o > 0 und o ≦ m gilt, sowie R₃ (C₁-C₃)Alkyl bedeutet. Insbesondere ist o und m gleich l.

Ist o≠0, so ist D vorzugsweise gleich A oder C, und B bedeutet in diesem Fall einen Oxa-n-alkylen-, insbesondere einen Oxa-n-(C₃ oder C₅)alkylen-Rest.

Besonders bevorzugt ist aber, wenn o=0 ist, und die Summe aus l, m und n 3-40 ergibt.

Eine weitere bevorzugte Ausführungsform liegt vor, wenn A gleich C, aber ungleich B bedeutet. In diesem Fall wird bevorzugt, daß A bzw. C ein Oxa-n-(C₂-C₄)alkylen- und B ein Oxa-n- oder -iso-(C₂ oder C₃)alkylen-Rest bedeutet. Insbesondere wird hierbei für B ein Oxa-iso-alkylen-Rest bevorzugt.

Weiterhin bevorzugt ist, wenn m=0 bedeutet (d.h. auch o=0), und die Summe aus l und n 3-40 erreicht. A und C stehen in diesem Fall für Oxa-n- oder -iso-(C₁-C₅)alkylen, insbesondere für Oxa-n- oder -iso-(C₂ oder C₃)alkylen, wobei A oder C mindestens in der Weise unterschiedlich sind, daß sie nicht gemeinsam einen Oxa-n- oder einen Oxa-iso-alkylen-Rest bedeuten.

Bevorzugt ist aber eher diejenige Variante, in der l und m bzw. m und n jeweils gleich 0 bedeuten (o ist in diesem Fall ebenso 0). In diesem Fall ist C bzw. A ein Oxa-n- oder -iso-(C₂-C₅)alkylen, insbesondere ein Oxa-n- oder -iso-(C₂ oder C₃)alkylen.

R₁ und R₂ bedeuten in allen Fällen (C₁-C₃)Alkyl. Insbesondere sind R₁ und R₂ gleich und besonders bevorzugt Methyl.

Das mittlere Molekulargewicht des Polyglykolethers gemäß der allgemeinen Formel I beträgt 100 bis 1.400, insbesondere 200 bis 1.200, besonders bevorzugt 200 bis 600.

Das erfindungsgemäße photopolymerisierbare elastomere Gemisch enthält 0,1 bis 40 Gew.-%, vorzugsweise 0,5 bis 20 Gew.-%, mindestens einen Zusatz gemäß der allgemeinen Formel I, jeweils bezogen auf das in dem Gemisch enthaltende elastomere Bindemittel. Besonders bevorzugt wird der Zusatz lediglich einer Verbindung gemäß der allgemeinen Formel I.

Als elastomere Bindemittel sind Polymerisate aus konjugierten aliphatischen Dienen mit 4 bis 5 C-Atomen geeignet. Insbesondere sind zu nennen: Naturkautschuke, Homo- oder Copolymerisate von Butadien und Isopren, Copolymerisate von Butadien und/oder Isopren mit anderen Monomeren wie Styrol, Vinyltoluol, Acrylnitril oder (Meth)Acrylsäureester, z.B. Nitrilkautschuke, statistische Styrol/Butadien-, Styrol/Isopren-, und Styrol/Isopren/Butadien-Copolymerisate oder auch Blockcopolymerisate aus Styrolmonomeren und Butadien und/oder Isopren mit einem Styrolgehalt von 10 bis 50 Gew.-%. Elastomere Bindemittel dieser Art sind in der DE-A-22 15 040 beschrieben.

Das erfindungsgemäße photopolymerisierbare Gemisch enthält im allgemeinen 20 bis 98 Gew.-%, vorzugsweise 30 bis 95 Gew.-%, wenigstens einer der genannten elastomeren Bindemitteltypen. Es enthält weiterhin mindestens eine radikalisch polymerisierbare, olefinisch ungesättigte Verbindung sowie mindestens einen Photoinitiator.

Geeignete Monomere mit einer oder mehreren polymerisierbaren olefinischen Doppelbindungen sind insbesondere Ester und Amide der Acryl- und Methacrylsäure. Beispiele sind die verträglichen Mono- und Diacrylate und -methacrylate von ein- oder mehrwertigen Alkoholen wie Ethylenglykol, Di-, Tri-, Tetra- oder Polyethylenglykolen, letztere bevorzugt mit 10 bis 15 Ethylenglykoleinheiten, 1,3-Propandiol, 1,6-Hexandiol, Dodecandiol, Glycerin, 1,1,1-Trimethylolpropan, 1,2,4-Butantriol oder Pentaerythrit, z. B. Ethylenglykolmonomethacrylat, 1,3-Propandiolmonomethacrylat, Glycerinmono- und -diacrylat, 1,2,4-Butantriolmonomethacrylat, Hexandioldiacrylat, Hexandioldimethacrylat, Dodecandioldiacrylat, 2-Ethylhexylacrylat, Laurylmethacrylat, Stearylmethacrylat, Pentaerythrittriacrylat, Polyethylenglykolmethyletheracrylat, Tetradecaethylenglykol-dimethacrylat oder der Triether aus Glycerin und 3 mol N-Methylolacrylamid oder -methacrylamid. Ebenso sind Alkenylphosphon- und -phosphinsäureester nach der P 38 17 424.3 anwendbar. Die Menge an Monomeren liegt im allgemeinen bei etwa 1 bis 70 Gew.-%, bevorzugt bei etwa 2 bis 50 Gew.-%, bezogen auf die nichtflüchtigen Betandteile des Gemischs.

Als Photoinitiatoren für das erfindungsgemäße Gemisch kommen die bekannten Verbindungen in Frage, die eine hinreichende thermische Stabilität bei der Verarbeitung der Aufzeichnungsmaterialien sowie eine hinreichende Radikalbildung bei Belichtung unter Initiierung der Polymerisation der Monomeren aufweisen. Sie sollen Licht im Wellenlängenbereich von ca. 250 bis ca. 500 nm unter Bildung von Radikalen absorbieren. Beispiele geeigneter Photoinitiatoren sind Acyloine und deren Derivate wie Benzoin, Benzoinalkylether, z. B. Benzoinisopropylether, vicinale Diketone und deren Derivate, z. B. Benzil, Benzilacetale wie Benzildimethylketal, Fluorenone, Thioxanthone, Mehrkernchinone, Acridine und Chinoxaline; ferner Trichlormethyl-s-triazine, 2-Halogenmethyl-4-vinyl-1,3,4-oxadiazolderivate, mit Trichlormethylgruppen substituierte Halogenoxazole, Trihalogenmethylgruppen enthaltende Carbonylmethylenheterocyclen gemäß DE-A 33 33 450, Acylphosphinoxidverbindungen, wie sie z. B. in der DE-A 31 33 419 beschrieben sind, und andere phosphorhaltige Photoinitiatoren, z. B. die in der deutschen Patentanmeldung P 38 27 735.2 beschriebenen 6-Acyl-(6H)-dibenz[c,e] [1,2]oxaphosphorin-6-oxide, insbesondere das 6-(2,4,6-Trimethylbenzoyl)-(6H)-dibenz-[c,e] [1,2] oxaphosphorin-6-oxid. Die Photoinitiatoren lassen sich auch in Kombination miteinander oder mit Coinitiatoren bzw. Aktivatoren verwenden, z. B. mit Michlers Keton und seinen Derivaten oder 2-Alkyl-anthrachinonen. Die Menge an Photoinitiator beträgt im allgemeinen etwa 0,01 bis 10 Gew-%, bevorzugt etwa 0,5 bis 5 Gew.-%, bezogen auf das photopolymerisierbare Gemisch.

Oft ist es von Vorteil, dem photopolymerisierbaren Gemisch noch weitere Hilfs- und Zusatzstoffe zuzugeben, z. B. Inhibitoren der thermischen Polymerisation wie Hydrochinon und seine Derivate, 2,6-Di-tert.-butyl-p-kresol, Nitrophenole, Nitrosamine wie N-Nitrosodiphenylamin oder Salze des N-Nitrosocyclohexylhydroxylamins, z.B. dessen Alkali- oder Aluminiumsalze. Weitere übliche Zusätze sind Farbstoffe, Pigmente, Weichmacher, Lichthofschutzmittel, Antioxidantien, Vernetzungsmittel, Regler, Füllmittel, Flußmittel und weitere die Schicht in ihrer Funktion verbessernde Hilfsmittel.

Das erfindungsgemäße Gemisch läßt sich für die Herstellung von Relief- und Flexodruckplatten durch Gießen aus einer Lösung mit einem organischen Lösemittel und durch Verkneten bei höheren Temperaturen und anschließendem Verpressen verwenden. Die Herstellung kann auch durch Extrudieren in einem Ein- oder Zweischneckenextruder und anschließendem Ausformen durch ein Glättwerk oder einen Kalander zu Schichten einer Dicke von 0,1 bis 10, vorzugsweise von 0,4 bis 6 mm, erfolgen. Ebenso ist die Herstellung nach dem Rollerheadverfahren möglich. Die in der beschriebenen Weise hergestellte Schicht kann auf die Oberfläche eines geeigneten Trägers laminiert werden oder es kann eine Lösung des erfindungsgemäßen Gemisches auf einen Schichtträger aufgebracht werden.

Außer für die Herstellung von Reliefdruckplatten kann das erfindungsgemäße Gemisch z.B. auch zur Herstellung von Flachdruckplatten, Tiefdruckzylindern, Siebdruckschablonen und Photoresists verwendet werden.

Geeignete Träger sind je nach Verwendungszweck z. B. Polyesterfolien, Stahl- oder Aluminiumbleche, Kupferzylinder, Siebdruckschablonenträger, Schaumstofflagen, gummielastische Träger oder Leiterplatten. Es kann auch vorteilhaft sein, auf die lichtempfindliche Aufzeichnungsschicht eine Deck- bzw. Schutzschicht, z. B. eine dünne Schicht aus Polyvinylalkohol, oder eine abziehbare Deckfolie, z. B. aus Polyethylenterephthalat oder Polyamid aufzubringen. Weiterhin kann eine Vorbeschichtung des Trägers vorteilhaft sein. Die zusätzliche Schicht zwischen dem Träger und der lichtempfindlichen Schicht kann z. B. als Lichthofschutzschicht oder als Haftschicht wirksam sein.

Das erfindungsgemäße Aufzeichnungsmaterial kann bildmäßig mit aktinischem Licht aus Lichtquellen wie Quecksilberdampflampen oder Leuchtstoffröhren belichtet werden, wobei die emittierte Wellenlänge bevorzugt zwischen 300 und 420 nm liegt.

Das Entfernen der unbelichteten und unvernetzten Schichtanteile kann durch Sprühen, Waschen oder Bürsten mit chlorierten Kohlenwasserstoffen, Estern, aromatischen Verbindungen oder Phenolethern, wie sie in der DE-A-22 15 090 und den noch nicht veröffentlichten deutschen Patentanmeldungen P 38 36 402.6, P 38 36 403.4 und P 38 36 404.2 beschrieben werden, erfolgen. Der Lösung können ferner kleine Mengen Entschäumer oder mit Wasser mischbare organische Lösemittel, z.B. niedere aliphatische Alkohole, zugesetzt werden.

Zweckmäßig werden die entwickelten Reliefformen bei Temperaturen bis 120 °C getrocknet und gegebenenfalls gleichzeitig oder danach mit aktinischem Licht nachbelichtet. Nach dem Trocknen der Flexodruckform kann diese mit einer halogenhaltigen Lösung wie z.B. einer Brom- oder Chlorlösung nachbehandelt werden. Ebenso ist eine Nachbehandlung mit aktinischem Licht, insbesondere mit einer Wellenlänge von < 300 nm, möglich. Vor der bildmäßigen Belichtung kann von der gegenüberliegenden Seite kurzzeitig ebenfalls mit aktinischem Licht vollflächig belichtet werden.

Das erfindungsgemäße Aufzeichnungsmaterial eignet sich besonders zur Herstellung von Druckformen, vor allem von Hoch- oder Reliefdruckformen, die besonders für den Flexodruck geeignet sind.

Die Erfindung wird durch die nachstehenden Beispiele erläutert. In den Beispielen steht Gt für Gewichtsteile; wenn nichts anderes angegeben, gilt für g:cm³ l:l.

### Beispiel 1 (Vergleichsbeispiel)

Es wurde ein photopolymerisierbares elastomeres Gemisch hergestellt, bestehend aus

| | |
|---|---|
| 90 Gt | eines Styrol/Isopren/Styrol-Dreiblockcopolymeren mit einem Gehalt von 15 Gew.-% an Styrol, |
| 8 Gt | Hexandioldiacrylat, |
| 2 Gt | Benzildimethylketal und |
| 0,3 Gt | 2,6-Di-tert.-butyl-4-methylphenol in |
| 100 Gt | Toluol. |

Das Gemisch wurde auf eine 125 µm dicke, biaxial verstreckte und thermofixierte Polyesterfolie in einem Metallrahmen zu einer 6 mm dicken Schicht ausgegossen. Nach dem Verdunsten des Toluols wurde auf die freie Oberfläche der nun 3 mm dicken festen Photopolymerschicht eine mit einer Haftschicht versehene, 125 µm dicke, biaxial versteckte und thermofixierte Polyesterfolie aufgelegt und das entstandene Dreischichtenelement in einer Plattenpresse bei 110° C unter Verwendung von 2,7 mm dicken Distanzstücken bei einem Druck von 400 N/cm 5 min gepreßt.

Nach dem Abziehen derjenigen Polyesterfolie, die nicht mit einem Haftvermittler behandelt worden war, wurde an deren Stelle ein Overcoat aus Polyamid in einer Dicke von 3-4 µm auflaminiert. Zuerst erfolgte eine vollflächige Belichtung der photopolymeren Schicht durch die verbliebene Polyesterfolie. Hierzu wurde das liehrschichtenelement der Strahlung eines handelsüblichen UV-A-Flachbelichters (Spektralbereich 320-400 nm, Intensität der Strahlung an der Photopolymeroberfläche: 14 mW/cm) für 10 s ausgesetzt. Anschließend erfolgte die bildmäßige Belichtung mit derselben Strahlungsquelle für 30 min, jedoch von der gegenüberliegenden Seite des Mehrschichtenelements aus.

Entwickelt wurde mit Perchlorethylen. Nach dem Trocknen der entstandenen Flexodruckform wurde mit einer 0,4-Gew.-%igen wäßrigen Bromlösung 5 min nachbehandelt, worauf 10 min mit Wasser gespült wurde.

Die Flexodruckform wurde anschließend für 10 min im handelsüblichen Flachbelichter nachbelichtet.

Anschließend wurde die Flexodruckform auf einen Zylinder von 7 cm Durchmesser gespannt und in einer Kammer ozonhaltiger Luft (0,5 ppm Ozon) ausgesetzt. Die Platte wurde zum einen danach beurteilt, zu welcher Zeit sich erste Risse zeigen (mit bloßem Auge sichtbare Risse), und danach, wieviel Risse nach einer 20stündigen Ozonbehandlung entstanden waren. Die Ergebnisse sind in Tabelle 1 zusammengefaßt.

### Beispiel 2 (Vergleichsbeispiel)

Es wurde ein photopolymerisierbares elastomeres Gemisch entsprechend Beispiel 1 hergestellt, jedoch mit einem Zusatz von 5 Gt Dipropylenglykolmonomethylether. Das elastomere Gemisch wurde, wie in Beispiel 1 angegeben, zu einer Flexodruckplatte weiterverarbeitet und ebenso dem Test in der Ozonkammer ausgesetzt. Das Ergebnis ist vergleichbar mit dem aus Beispiel 1. Der Zusatz scheint keine Wirkung in der Platte zu entfalten. Das Ergebnis ist aus Tabelle 1 ersichtlich.

### Beispiel 3

Es wurde ein photopolymerisierbares elastomeres Gemisch entsprechend Beispiel 1 hergestellt, jedoch mit einem Zusatz von 10 Gt an Tetraethylenglykoldimethylether. Das elastomere Gemisch wurde, wie in Beispiel 1 angegeben, zu einer Flexodruckplatte weiterverarbeitet und ebenso dem Test in der Ozonkammer ausgesetzt. Die Ergebnisse sind aus Tabelle 1 ersichtlich.

### Beispiel 4

Es wurde ein photopolymerisierbares elastomeres Gemisch entsprechend Beispiel 1 hergestellt, jedoch mit einem Zusatz von 5 Gt an Polyethylenglykoldimethylether mit einem mittleren Molekulargewicht von 250. Das elastomere Gemisch wurde, wie in Beispiel 1 angegeben, zu einer Flexodruckplatte weiterverarbeitet und ebenso dem Test in der Ozonkammer ausgesetzt. Die Ergebnisse sind in Tabelle 1 zusammengefaßt.

### Beispiel 5

Anstelle von Polyethylenglykoldimethylether eines Molekulargewichts von 250 wurden in diesem Beispiel 5 Gt an Polyethylenglykoldimethylether eines mittleren Molekulargewichts von 500 eingesetzt. Die Vorgehensweise entsprach ansonsten der des Beispiels 4. Die Ergebnisse zeigt Tabelle 1.

### Beispiel 6

Es wurde ein photopolymerisierbares elastomeres Gemisch hergestellt, bestehend aus

| | |
|---|---|
| 90 Gt | eines Styrol/Isopren/Styrol-Dreiblockcopolymeren mit einem Gehalt von 15 Gew.-% an Styrol, |
| 8 Gt | Hexandioldiacrylat, |
| 2 Gt | Benzildimethylketal, |
| 0,3 Gt | 2,6-Di-tert.-butyl-4-methylphenol und |
| 5 Gt | Polyethylenglykoldimethylether (mittleres Molekulargewicht 250). |

Das Gemisch wurde in einem Kneter 15 min bei 150° C geknetet. Anschließend wurde die Mischung auf eine mit einer Haftschicht versehenen, 125 µm dicken, biaxial verstreckten und thermofixierten Polyesterfolie aufgebracht, und die entstehende Schicht mit der gleichen Polyesterfolie, jedoch ohne Haftschicht, abgedeckt. Das erzeugte Mehrschichtenelement wurde in einer Plattenpresse bei 110° C unter Verwendung von 2,7 mm dicken Distanzstücken für 2 min gepreßt. Nach dem Abziehen der nicht mit einem Haftmittel beschichteten Polyesterfolie wurde entsprechend dem Beispiel 1 weiterverarbeitet. Das Ergebnis dieses Versuchs ist ebenso in Tabelle 1 verdeutlicht.

**Tabelle 1**

| Behandlung der Flexodruckform mit ozonhaltiger Luft (0,5 ppm Ozon) | | |
|---|---|---|
| Beispiel | Beginn der Rißbildung | Rißhäufigkeit nach 20 h |
| 1 | 2 min | viele |
| 2 | 2 min | viele |
| 3 | 1 h | wenige |
| 4 | 1 h | wenige |
| 5 | 3 h | wenige |
| 6 | 2 h | wenige |

Tabelle 1 verdeutlicht, daß aus dem erfindungsgemäßen photopolymerisierbaren elastomeren Gemisch mit dem Polyglykolether nach der allgemeinen Formel I Flexodruckformen hergestellt werden können, die in überraschender Weise wesentlich resistenter gegenüber ozonhaltiger Luft sind als Flexodruckformen, die bisher dem Fachmann bekannt waren.

## Patentansprüche

1. Photopolymerisierbares elastomeres Gemisch zur Herstellung von ozonresistenten Flexodruckformen, ausgenommen solchen, die mit Wasser entwickelbar sind, im wesentlichen enthaltend ein elastomeres Bindemittel, eine radikalisch polymerisierbare olefinisch ungesättigte Verbindung und einen Photoinitiator, dadurch gekennzeichnet, daß das Gemisch mindestens einen Polyglykolether nach der allgemeinen Formel I 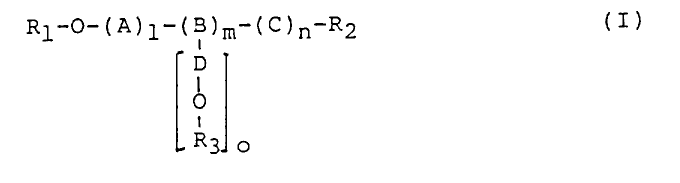 enthält, worin
R₁ und R₂ Alkyl, insbesondere (C₁-C₃)Alkyl,
R₃ Wasserstoff oder Alkyl, insbesondere (C₁-C₃)Alkyl,
A, B, C und D gleich oder verschieden sein können und Oxa- n- oder -iso-alkylen, insbesondere Oxa-n- oder -iso-(C₁-C₅)alkylen und
l+m+n+o 3 bis 40
bedeuten.

2. Photopolymerisierbares Gemisch nach Anspruch 1, dadurch gekennzeichnet, daß für m und o > 0
D A oder C,
B Oxa-n-alkylen, insbesondere Oxa-n-(C₃ oder C₅)alkylen und
R₁, R₂ und R₃ (C₁-C₃)Alkyl
bedeuten.

3. Photopolymerisierbares Gemisch nach Anspruch 1, dadurch gekennzeichnet, daß für m=0 und o=0 die Summe aus 1 und n 3 bis 40 ergibt und
A und C Oxa-n- oder -iso-(C₁-C₅)alkylen, insbesondere Oxa-n- oder -iso-(C₂ oder C₃)alkylen, sowie
R₁ und R₂ (C₁-C₃)Alkyl
bedeuten.

4. Photopolymerisierbares Gemisch nach den Ansprüchen 1 oder 3, dadurch gekennzeichnet, daß
für 1 und m gleich 0
C Oxa-n- oder -iso-(C₂-C₅)alkylen, insbesondere Oxa-n- oder -iso-(C₂ oder C₃)alkylen
und für m und n gleich 0
A Oxa-n- oder -iso-(C₂-C₅)alkylen, insbesondere Oxa-n- oder -iso-(C₂ oder C₃)alkylen sowie jeweils
R₁ und R₂ (C₁-C₃)Alkyl, insbesondere Methyl bedeuten.

5. Photopolymerisierbares Gemisch nach einem oder mehreren der Ansprüche 1 bis 4, dadurch gekennzeichnet, daß das mittlere Molekulargewicht des Polyglykolethers gemäß der allgemeinen Formel I 100 bis 1.400, insbesondere 200 bis 1.200, beträgt.

6. Photopolymerisierbares Gemisch nach einem oder mehreren der Ansprüche 1 bis 5, dadurch gekennzeichnet, daß das Gemisch nur eine der Verbindungen entsprechend der allgemeinen Formel I enthält.

7. Photopolymerisierbares Gemisch nach einem oder mehreren der Ansprüche 1 bis 6, dadurch gekennzeichnet, daß das Gemisch einen Polyglykolether gemäß der allgemeinen Formel I in einer Konzentration von 0,1 bis 40 Gew.-%, insbesondere von 0,5 bis 20 Gew.-%, enthält.

8. Photopolymerisierbares Gemisch nach einem oder mehreren der Ansprüche 1 bis 7, dadurch gekennzeichnet, daß das Gemisch als elastomeres Bindemittel ein Polymerisat aus konjugierten aliphatischen Dienen mit 4 bis 5 C-Atomen, in einer Konzentration von 20 bis 98 Gew.-%, insbesondere von 30 bis 95 Gew.-%, enthält.

9. Photopolymerisierbares Gemisch nach einem oder mehreren der Ansprüche 1 bis 8, dadurch gekennzeichnet, daß das Gemisch die radikalisch polymerisierbare olefinisch ungesättigte Verbindung in einer Konzentration von 1 bis 70 Gew.-%, insbesondere von 2 bis 50 Gew.-%, enthält.

10. Photopolymerisierbares Gemisch nach einem oder mehreren der Ansprüche 1 bis 9, dadurch gekennzeichnet, daß das Gemisch einen Photoinitiator enthält, der Licht im Wellenlängenbereich von ca. 250 bis 500 nm absorbiert und im Gemisch in einer Konzentration von 0,01 bis 10 Gew.-% enthalten ist.

11. Aufzeichnungsmaterial zur Herstellung von ozonresistenten Flexodruckformen, im wesentlichen bestehend aus einem Träger und einem darauf aufgebrachten photopolymerisierbaren elastomeren Gemisch, dadurch gekennzeichnet, daß es als photopolymeriserbares Gemisch ein Gemisch gemäß einem oder mehreren der Ansprüche 1 bis 10 enthält.

12. Verfahren zur Herstellung einer ozonresistenten Flexodruckform, im wesentlichen bestehend aus folgenden Verfahrensschritten:
a) Herstellung des erfindungsgemäßen photopolymerisierbaren Gemisches gemäß einem oder mehreren der Ansprüche 1 bis 10, indem entweder die Bestandteile in einem Ein- oder Zweischneckenextruder extrudiert werden, die Ausformung anschließend in einem Glättwerk oder einem Kalander erfolgt oder indem die Herstellung nach dem Rollerheadverfahren erfolgt oder indem die Bestandteile in einem organischen Lösemittel gelöst werden, bei höheren Temperaturen vernetzt werden und anschließend verpreßt werden,
b) Auftragen bzw. Auflaminieren der in a) hergestellten Schicht oder Lösung auf einem ggf. haftschichtbehandelten Träger,
c) ggf. Abdecken der photopolymerisierbaren Schicht mit einer Deck- bzw. Schutzschicht,
d) bildmäßiges Belichten mit aktinischem Licht,
e) Entfernen der unbelichteten und unvernetzten Schichtenteile mit einem Entwicklungslösemittel sowie
f) Trocknen der Flexodruckform.

13. Verfahren nach Anspruch 12, dadurch gekennzeichnet, daß vor dem bildmäßigen Belichten (d) vollflächig von der gegenüberliegenden Seite kurzzeitig ebenfalls mit aktinischem Licht belichtet wird.

14. Verfahren nach den Ansprüchen 12 oder 13, dadurch gekennzeichnet, daß die Flexodruckform nach dem Trocknen (f) mit einer Halogenlösung, insbesondere mit Bromlösung, nachbehandelt oder mit aktinischem Licht nachbelichtet wird.

## Claims

1. A photopolymerizable elastomeric mixture for producing ozone-resistant flexographic printing forms except such which are developable with water, essentially containing an elastomeric binder, an olefinically unsaturated compound polymerizable by free radicals, and a photoinitiator, characterized in that, the mixture comprises at least one polyglycol ether of the general formula I 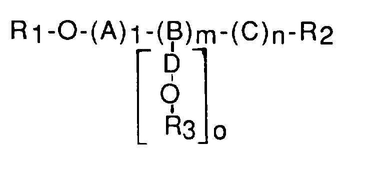 in which
R₁ and R₂ are alkyl, especially (C₁-C₃)-alkyl,
R₃ is hydrogene or alkyl, especially (C₁-C₃)-alkyl,
A,B,C and D can be identical or different and are oxa-n- or -iso-alkylene, especially oxa-n- or -iso-(C₁-C₅)-alkylene, and
l+m+n+o is 3 to 14.

2. A photopolymerizable mixture according to claim 1,
characterized in that,
for m and o are > 0,
D is A or C,
B is oxa-n-alkylene, especially oxa-n-(C₃ or C₅)-alkylene and
R₁, R₂ and R₃ are (C₁ -C₃)-alkyl.

3. A photopolymerizable mixture according to claim 1,
characterized in that,
for m=0 and o=0, the sum of I and n gives 3 to 40 and
A and C are oxa-n- or -iso-(C₁-C₅)-alkylene, especially oxa-n- or -iso-(C₂ or C₃)-alkylene and
R₁ and R₂ are (C₁-C₃)-alkyl.

4. A photopolymerizable mixture according to one or more of claims 1 or 3,
characterized in that,
for I and m equal to 0
C is oxa-n- or -iso-(C₂-C₅)-alkylene, especially oxa-n- or -iso-(C₂ or C₃)-alkylene,
and for m and n equal to 0,
A is oxa-n- or -iso-(C₂-C₅)-alkylene, especially oxa-n- or -iso-(C₂ or C₃)-alkylene, and in each case
R₁ and R₂ are (C₁-C₃)-alkyl, especially methyl.

5. A photopolymerizable mixture according to one or more of claims 1 to 4,
characterized in that,
the average molecular weight of the polyglycol ether of the general formula I is 100 to 1400, especially 200 to 1200.

6. A photopolymerizable mixture according to one or more of claims 1 to 5,
characterized in that,
the mixture contains only one of the compounds of the general formula I.

7. A photopolymerizable mixture according to one or more of claims 1 to 6,
characterized in that,
the mixture contains a polyglycol ether of the general formula I in a concentration from 0.1 to 40% by weight, especially from 0.5 to 20% by weight.

8. A photopolymerizable mixture according to one or more of claims 1 to 7,
characterized in that,
the mixture contains as the elastomeric binder a polymer of conjugated aliphatic dienes having 4 to 5 carbon atoms in a concentration from 20 to 98% by weight, especially 30 to 95% by weight.

9. A photopolymerizable mixture according to one or more of claims 1 to 8,
characterized in that,
the mixture contains the olefinically unsaturated compound polymerizable by free radicals in a concentration from 1 to 70% by weight, especially from 2 to 50% by weight.

10. A photopolymerizable mixture according to one or more of claims 1 to 9,
characterized in that,
the mixture contains a photoinitiator which absorbs light in the wavelength region from about 250 to 500 nm and is present in the mixture in a concentration from 0.01 to 10% by weight.

11. A recording material producing ozone-resistant flexographic printing forms, essentially composed of a carrier and a photopolymerizable elastomeric mixture applied thereon,
characterized in that,
it contains as the photopolymerizable mixture a mixture according to one or more of claims 1 to 10.

12. A process for producing an ozone-resistant flexographic printing form, essentially comprising the following process steps:
a) preparing the photopolymerizable mixture according to one or more of claims 1 to 10, either by extruding the constituents in a single-screw or twin-screw extruder and subsequent final forming in a polishing stack or a calender, or by carrying out the preparation by the roller head process or by dissolving the constituents in an organic solvent, followed by crosslinking at elevated temperatures and then pressing ,
b) applying or laminating of the layer or solution prepared in a) to a support optionally carrying an adhesion layer,
c) optionally covering the photopolymerizable layer with a covering layer or protective layer,
d) imagewise exposing with actinic light,
e) removing of the unexposed and uncrosslinked layer areas by a developer solvent and
f) drying of the flexographic printing form.

13. The process according to claim 12,
characterized in that,
before the imagewise exposure (d), the whole area is briefly exposed likewise with actinic light from the opposite side.

14. The process according to claims 12 or 13,
characterized in that,
after drying (f), the flexographic printing form is after-treated with a halogen solution, especially with a bromine solution, or after-exposed with actinic light.

## Revendications

1. Un mélange élastomère photopolymérisable quand la fabrication de plaques d'impression flexographique résistant à l'ozone, à l'exclusion de celles qui sont développables à l'eau, contenant essentiellement un liant élastomère, un dérivé à insaturation oléfinique polymérisable par voie radicalaire, et un photoinitiateur, caractérisé en ce que le mélange comprend au moins un polyglycol éther présentant la formule I 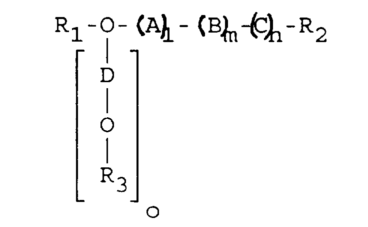 dans laquelle:
- R₁ et R₂ sont des radicaux alkyle, en particulier des radicaux alkyle en C₁-C₃,
- R₃ est un atome d'hydrogène ou un radical alkyle, en particulier un radical alkyle en C₁-C₃,
- A, B, C qui peuvent être identiques ou différents sont un radical oxa-n-alkyléne ou -iso-alkylène, en particulier un radical oxa-n-alkyléne ou -iso-alkylène en C₁C₅ et
- l+m+n+o est compris entre 3 et 40.

2. Un mélange photopolymérisable selon la revendication 1, caractérisé en ce que,
quand m et o > 0,
- D est A ou C,
- B est un radical oxa-n-alkylène, en particulier un radical oxa-n-alkylène en C₃ ou C₅ et
- R₁, R₂ et R₃ sont des radicaux alkyl en C₁-C₃.

3. Un mélange photopolymérisable selon la revendication 1, caractérisé en ce que,
quand m = 0 et o=0, la somme de l + n est comprise entre 3 et 40, et
- A et C sont des radicaux oxa-n-alkyléne ou -iso-alkylène en C₁-C₅, en particulier oxa-n-alkyléne ou -iso-alkylène en C₂-C₃ et
- R₁ et R₂ sont des radicaux alkyle en C₁-C₃.

4. Un mélange photopolymérisable selon l'une ou plusieurs des revendications 1 à 3, caractérisé en ce que:
quand l et m égal à 0,
- C est un radical oxa-n-alkyléne ou -iso-alkylène en C₂-C₅, en particulier un radical oxa-n-alkyléne ou iso-alkényle en C₂ ou C₃,
et quand m et n égal à 0,
- A est un radical oxa-n ou -iso-alkylène en C₂-C₅, en particulier un oxa-n-alkyléne ou -iso-alkylène en C₂ ou C₃, et dans chaque cas,
- R₁ et R₂ sont des radicaux alkyle en C₁-C₃, en particulier méthyle.

5. Un mélange photopolymérisable selon une ou plusieurs des revendications 1 à 4, caractérisé en ce que le poids moléculaire moyen du polyglycol éther de formule générale 1 est compris entre 100 et 1400, en particulier entre 200 et 1200.

6. Un mélange photopolymérisable selon une ou plusieurs des revendications 1 à 5, caractérisé en ce que le mélange ne contient que l'un des composés de formule générale I.

7. Un mélange photopolymérisable selon une ou plusieurs des revendications 1 à 6, caractérisé en ce que le mélange contient un polyglycol éther de formule générale I, à une concentration comprise entre 0,1 et 40% en poids, en particulier entre 0,5 et 20% en poids.

8. Un mélange photopolymérisable selon une ou plusieurs des revendications 1 à 7, caractérisé en ce que le mélange contient, en tant que liant élastomère, un polymère de diène aliphatique conjugué comportant 4 ou 5 atomes de carbone, à une concentration comprise entre 20 et 98%, en particulier de 30 à 95% en poids.

9. Un mélange photopolymérisable selon une ou plusieurs des revendications 1 à 8, caractérisé en ce que le mélange contient le composé à insaturation oléfinique polymérisable par voie radicalaire, à une concentration comprise entre 1 et 70% en poids, en particulier entre 2 et 50% en poids.

10. Un mélange photopolymérisable selon une ou plusieurs des revendications 1 à 9, caractérisé en ce que le mélange contient un photoinitiateur qui absorbe la lumière dans la région des longueurs d'ondes comprise entre environ 250 et 500 nanomètres, et qui est présent dans le mélange à une concentration de 0,01 à 10% en poids.

11. Un matériau d'enregistrement produisant des plaques d'impression flexographiques résistant à l'ozone, composé essentiellement d'un support et d'un mélange élastomère photopolymère appliqué dessus, caractérisé en ce que il contient en tant que mélange photopolymérisable, un mélange selon une ou plusieurs des revendications 1 à 10.

12. Un procédé de fabrication d'une plaque d'impression flexographique résistant à l'ozone comprenant essentiellement les étapes suivantes:
a préparation du mélange photopolymérisable selon une ou plusieurs des revendications 1 à 10, soit par extrusion des constituants dans un extrudeur à simple vis ou à double vis, suivie d'un formage final dans une polisseuse ou une calandre, ou en effectuant la préparation par le procédé au rouleau ou par dissolution des constituants dans un solvant organique, suivi par une réticulation à température élevée et compression,
b application ou stratification de la couche ou solution préparée en a sur un support portant éventuellement une couche adhérente,
c éventuellement recouvrement de la couche photopolymérisable d'une couche de couverture ou d'une couche protectrice,
d exposition à la manière dont on forme une image à la lumière actinique,
e enlèvement des zones de couche non exposées et non réticulées par un solvant développeur et
f séchage de la plaque d'impression flexographique.

13. Le procédé selon la revendication 12, caractérisé en ce, avant l'étape d'exposition à la manière dont on forme une image (d, la surface totale est brièvement exposée de même façon à une lumière actinique au travers de la face opposée.

14. Le procédé selon la revendication 12 ou 13, caractérisé en ce que, après le séchage (f, la plaque d'impression flexographique subit un traitement supplémentaire à l'aide d'une solution halogénée, en particulier avec une solution bromée ou subit une exposition supplémentaire à une lumière actinique.
